Europäisches Patentamt

European Patent Office

Office européen des brevets

(11) Veröffentlichungsnummer: **0 326 856**
**A1**

## (12) EUROPÄISCHE PATENTANMELDUNG

(21) Anmeldenummer: 89100807.0

(22) Anmeldetag: 18.01.89

(51) Int. Cl.⁴: H03K 23/54 , H03K 23/00

(30) Priorität: 28.01.88 DE 3802530

(43) Veröffentlichungstag der Anmeldung:
09.08.89 Patentblatt 89/32

(84) Benannte Vertragsstaaten:
DE FR GB IT NL

(71) Anmelder: Siemens Aktiengesellschaft Berlin
und München
Wittelsbacherplatz 2
D-8000 München 2(DE)

(72) Erfinder: Hölzle, Josef, Dipl.-Ing.
Neubeuernerstrasse 11
D-8000 München 21(DE)

(54) Elektronischer Impulszähler.

(57) Der Impulszähler wird aus einer gegebenen Anzahl von Schieberegistern (SR1...SR4) aufgebaut, die eine unterschiedliche Anzahl von Speicherelementen (FF1...FF15) aufweisen. Die jeweilige Zahl von Speicherelementen umfaßt vorzugsweise bei 1 beginnend Potenzen von 2. Die Schieberegister (SR1...SR4) sind jeweils durch eine Negation zwischen Eingang (DS1...DS4) und Ausgang (V1...V4) gegengekoppelt. Als Eingang (E) des Impulszählers dient die gemeinsame Taktleitung (CS1...CS4) aller Schieberegister und als Ausgänge des Impulszählers (AV,BV,CV, DV) die Ausgänge aller Schieberegister. Der Impulszähler führt darüber hinaus gleichzeitig eine Rückwärtszählsequenz aus, wenn die Ausgangszustände V1,R2,R3,R4 der jeweils ersten Speicherelemente der Schieberegister als Zählergebnis (AR,BR, CR,DR) verwendet werden.

FIG 1

## Elektronischer Impulszähler

Die Erfindung betrifft einen elektronischen Impulszähler.

Es ist generell üblich, elektronische Impulszähler als asynchrone oder synchrone Dualzähler auszuführen, wobei für höhere Impulsfolgefrequenzen synchrone Dualzähler aufgrund der prinzipiell höheren Grenzfrequenz asynchronen Dualzählern gegenüber im Vorteil sind. Synchrone Dualzähler bestehen in der Regel aus mehreren Speicherelementen, die über eine kombinatorische Logik miteinander verbunden sind. Die Grenzfrequenz des synchronen Dualzählers hängt von der Schaltzeit eines Speicherelementes und von der Laufzeit der kombinatorischen Logik ab. Da der schaltungstechnische Aufwand für die kombinatorische Logik mit der Zahl der Zählerstufen überproportional steigt, wird damit auch die Grenzfrequenz des synchronen Dualzählers erheblich eingeschränkt (z.B. Tietze-Schenk, "Halbleiterschaltungstecknik", Springer-Verlag, 5. Auflage 1980, Seite 494 und ff).

Der Erfindung liegt demgemäß die Aufgabe zugrunde, einen elektronischen Impulszähler zu realisieren, der eine hohe, von der Zahl seiner Stufen unabhängige, Grenzfrequenz aufweist.

Gelöst wird die vorstehend aufgezeigte Aufgabe bei einem elektronischen Impulszähler erfindungsgemäß dadurch, daß der elektronische Impulszähler aus einer gegebenen Anzahl von Schieberegistern mit unterschiedlicher Anzahl von Speicherelementen besteht, daß die Schieberegister durch eine Negation zwischen Eingang und Ausgang gegengekoppelt sind, daß der Eingang des Impulszählers durch die gemeinsame Taktleitung aller Schieberegister gegeben ist und daß die Ausgänge der Schieberegister die Ausgänge des Impulszählers sind.

Die Erfindung bringt den Vorteil mit sich, daß zum Aufbau des Impulszählers keine kombinatorische Logik notwendig ist, die durch ihre Laufzeit zu einer Verringerung der Grenzfrequenz beiträgt. Letztere wird, da alle Speicherelemente über die Taktleitung gleichzeitig geschaltet werden, nun ausschließlich von der Schaltzeit des langsamsten Speicherelementes der gesamten Schaltungsanordnung bestimmt.

Zweckmäßigerweise wird zur Bildung weiterer Ausgänge des Impulszählers der Ausgang des jeweils ersten Speicherelementes eines Schieberegisters herausgeführt. Der Vorteil liegt darin, daß ohne zusätzlichen schaltungstechnischen Aufwand ein rückwärtszählender Impulszähler realisiert wird. Darüber hinaus ist es vorteilhaft, daß die Ergebnisse des Vorwärts- und Rückwärts-Zählvorganges an verschiedenen Ausgängen gleichzeitig zur Verfügung stehen.

Es ist vorteilhaft, die Resetleitungen aller Speicherelemente zusammenzuführen und als Resetleitung des Impulszählers zu verwenden. Der Vorteil besteht darin, durch Aufschalten eines Impulses auf die Resetleitung den Zähler in einen definierten Grundzustand zu bringen.

Zweckmäßigerweise werden die Schieberegister mit nicht-transparenten Speicherelementen aufgebaut. Der Vorteil liegt in der höheren Betriebssicherheit von derart realisierten Schieberegistern.

Vorrangig sind als Speicherelemente in den Schieberegistern D-Flip-Flops und JK-Flip-Flops vorgesehen. Ihre Anwendung ist vorteilhaft, da sie die am weitesten verbreiteten nicht-transparenten Speicherelemente darstellen.

Vorzugsweise wird die Anzahl der Speicherelemente, aus denen die Schieberegister bestehen, so gewählt, daß sie bei 1 beginnend jeweils Potenzen der Zahl 2 ergeben. Der Vorteil liegt in der Realisation eines Dualzählers.

Durch Verwendung nur eines, aus einer gegebenen Anzahl von Speicherelementen bestehenden, gegengekoppelten Schieberegisters der eingangs geschilderten Schaltungsanordnung wird ein Frequenzteiler gebildet, dessen Vorteil darin besteht, daß das Teilerverhältnis nicht wie üblich nur eine Potenz von 2 umfaßt, sondern eine Vielfache von 2.

Die Erfindung wird nachfolgend anhand von den in den FIG der Zeichnung dargestellten Ausführungsbeispielen näher erläutert. Es zeigen:

FIG 1 ein Schaltbild einer ersten Ausführungsform einer obengenannten Schaltungsanordnung,

FIG 2 ein Schaltbild einer zweiten Ausführungsform einer obengenannten Schaltungsanordnung.

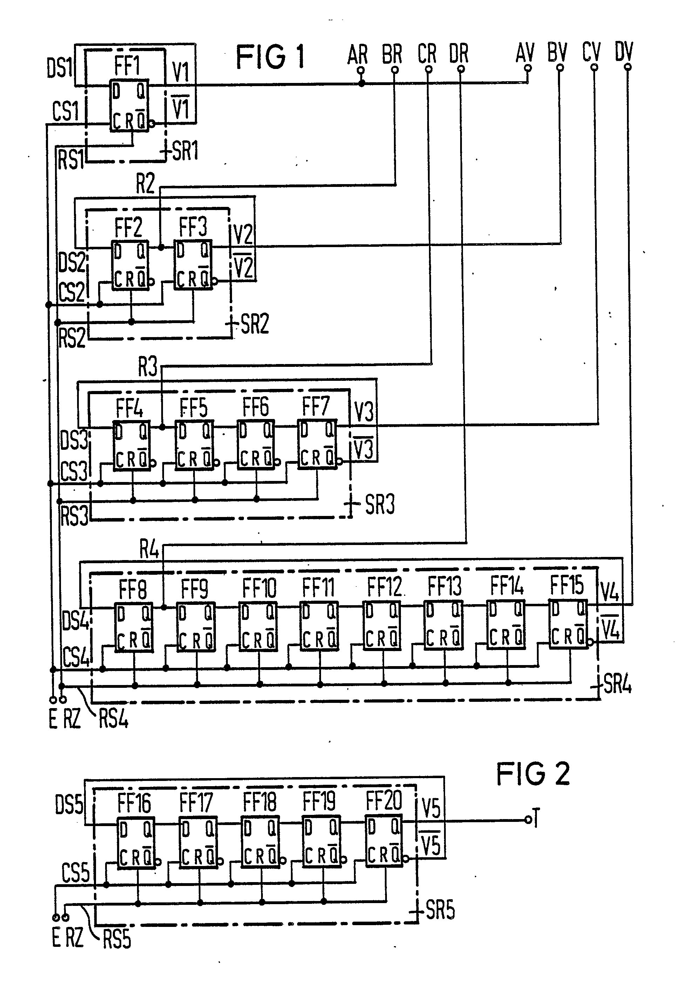

In der FIG 1 ist ein vierstelliger Dualzähler dargestellt, der aus vier Schieberegistern SR1 bis SR4 unterschiedlicher Länge aufgebaut ist. Die Schieberegister umfassen als Anzahl von Speicherelementen FF1 bis FF15 bei 1 beginnend jeweils Potenzen von 2, wodurch ihre Länge auf eins, zwei, vier und acht Speicherelemente festgelegt ist. Als Speicherelemente werden D-Flip-Flops verwendet, die durch Verbindung des Ausgangs Q eines D-Flip-Flops mit dem Eingang D des nachfolgenden D-Flip-Flops zu einem Schieberegister verschaltet sind. Die Gegenkopplung eines Schieberegisters erfolgt durch eine Verbindung eines negierten Ausganges $\overline{V1}$, $\overline{V2}$, $\overline{V3}$, $\overline{V4}$ eines Schieberegisters SR1, SR2, SR3, SR4 mit seinem Eingang DS1, DS2, DS3, DS4. Die Taktund Resetleitungen CS1 bis CS4 und RS1 bis RS4 aller Schieberegister sind jeweils zusammengeführt und bilden die Taktleitung E und Resetleitung RZ des Zählers, wobei die Taktleitung E als Zählereingang verwendet wird. Als Zählerausgang V1...V4, R2 ...R4 wird jeweils der Ausgang des ersten und des letzten Speicherelementes eines jeden Schieberegisters herausgeführt. Dabei repräsentieren die Ausgänge der ersten Speicherelemente V1,R2, R3,R4 die vier Stellen des Rückwärtszählers AR,BR,CR,DR und die Ausgänge der letzten Speicherelemente V1,V2,V3,V4 die vier Stellen des Vorwärtszählers AV,BV,CV,DV. Die Wertigkeit eines Ausgangs ist direkt proportional mit der Anzahl der Speicherelemente des jeweiligen Schieberegisters.

FIG 2 zeigt einen Impulszähler, der aus einem Schieberegister SR5 mit fünf D-Flip-Flops FF16 bis FF20 als Speicherelementen besteht. Das Schieberegister RS5 ist durch eine Verbindung zwischen Eingang DS5 und negiertem Ausgang $\overline{V5}$ gegengekoppelt. Ausgang V5 und Resetleitung RS5 des Schieberegisters RS5 sind gleichzeitig Ausgang T und Resetleitung RZ des Impulszählers. Als Eingang E des Impulszählers wird die Taktleitung CS5 des Schieberegisters verwendet.

Nachdem zuvor der prinzipielle Aufbau der in den FIG der Zeichnung dargestellten elektronischen Impulszähler erläutert worden sind, wird nunmehr auf deren Arbeitsweise näher eingegangen.

Die prinzipielle Funktion der gezeigten elektronischen Impulszähler beruht auf der Kombination von Frequenzteilern mit unterschiedlichen Teilungsverhältnissen auf der Basis von Schieberegistern. Die Arbeitsweise eines derartigen Frequenzteilers besteht nun darin, daß bei rückgesetztem Zähler die Ausgänge aller Speicherelemente, im vorliegenden Fall handelt es sich um D-Flip-Flops, den logischen Zustand 0 aufweisen. Am Eingang des ersten Speicherelements liegt deshalb eine 1 an, da dieser mit dem negierten Ausgang des Schieberegisters verbunden ist. Wird nun ein Impuls auf den Zählereingang gegeben, so übernimmt jedes Speicherelement den Ausgangszustand des vorhergehenden mit Ausnahme des ersten, das den negierten Ausgangszustand des letzten übernimmt. Damit wird der Ausgangszustand des ersten Speicherelements gleich 1. Bei jedem weiteren Eingangsimpuls wird nun der logische Zustand 1 um ein Speicherelement weitergeschoben, bis wie im vorliegenden Fall FIG 2 nach fünf Impulsen alle Speicherelemente den Zustand 1 aufweisen. Dadurch liegt jedoch am Eingang des ersten Speicherelements der Zustand 0 an, der wiederum nach weiteren fünf Impulsen am Ausgang erscheint.

Werden, wie in FIG 1 der Zeichnung gezeigt, vier derartige Frequenzteiler, deren Anzahl von Speicherelementen eins, zwei, vier und acht beträgt, parallel betrieben, so entsteht ein vierstelliger vorwärtszählender Dualzähler.

Am Ausgang des ersten Speicherelements eines Schieberegisters liegt der Ausgangszustand des jeweiligen Frequenzteilers negiert und um einen Impuls verzögert an. Bei einem wie in FIG 1 der Zeichnung aufgebauten Zähler erscheint deshalb an den Ausgängen der ersten Speicherelemente der Schieberegister eine vierstellige Dualzahl, deren Sequenz entgegengesetzt verläuft zu der, die an den Ausgängen der letzten Speicherelemente der jeweiligen Frequenzteiler liegt. Damit stehen die Ergebnisse des Vorwärts-und Rückwärtszählens an getrennten Ausgängen gleichzeitig zur Verfügung.

## Ansprüche

1. Elektronischer Impulszähler, **dadurch gekennzeichnet**, daß der Impulszähler aus einer gegebenen Anzahl von Schieberegistern (SR1...SR4) mit unterschiedlicher Anzahl von Speicherelementen (FF1...FF15) besteht, daß die Schieberegister (SR1...SR4) durch eine Negation zwischen Eingang (DS1...DS4) und Ausgang (V1...V4) gegengekoppelt sind, daß der Eingang (E) des Impulszählers durch die gemeinsame Taktleitung (CS1...CS4) aller Schieberegister gegeben ist und daß die Ausgänge (V1...V4) der Schieberegister (SR1...SR4) die Ausgänge (AV,BV,CV,DV) des Impulszählers sind.

2. Elektronischer Impulszähler nach Anspruch 1, **dadurch gekennzeichnet**, daß zur Bildung weiterer Ausgänge (AR,BR,CR,DR) des Impulszählers der Ausgang (V1,R2,R3,R4) des jeweils ersten Speicherelements eines Schieberegisters herausgeführt ist.

3. Elektronischer Impulszähler nach mindesten einem der Ansprüche 1 und 2, **dadurch gekennzeichnet**, daß als Resetleitung (RZ) des Impulszählers die zusammengeführten Resetleitung (RS1...RS4) aller Schieberegister (SR1 ...SR4) dienen.

4. Elektronischer Impulszähler nach mindesten einem der Ansprüche 1 bis 3, **dadurch gekennzeichnet**, daß die Schieberegister (SR1...SR5) aus nicht-transparenten Speicherelementen (FF1...FF20) aufgebaut sind.

5. Elektronischer Impulszähler nach Anspruch 4, **dadurch gekennzeichnet**, daß als nicht-transparente Speicherelemente D-Flip-Flops (FF1...FF20) vorgesehen sind.

6. Elektronischer Impulszähler nach Anspruch 4, **dadurch gekennzeichnet**, daß als nicht-transparente Speicherelemente JK-Flip-Flops vorgesehen sind..

7. Elektronischer Impulszähler nach mindestens einem der Ansprüche 1 bis 6, **dadurch gekennzeichnet,** daß die Schieberegister (SR1...SR4) des Impulszählers als Anzahl von Speicherzellen (FF1...FF16) bei 1 beginnend jeweils Potenzen von 2 aufweisen.

8. Elektronischer Impulszähler nach mindestens einem der Ansprüche 1 bis 7, **dadurch gekennzeichnet,** daß der Impulszähler aus nur einem, mit einer gegebenen Anzahl von Speicherelementen (FF16...FF20) aufgebauten, Schieberegister (SR5) besteht.

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | IBM TECHNICAL DISCLOSURE BULLETIN, Band 27, Nr. 1A, Juni 1984, Seiten 181-182, New York, US; G.E. HACK: "Universal counter function utilizing a shift register latch string" * Figuren 1-3; Seiten 181-182 * | 1,4,7 | H 03 K 23/54 H 03 K 23/00 |
| Y | IDEM | 2 | |
| Y | US-A-3 609 311 (WAYNE) * Figuren 1,2; Spalte 1, Zeile 70 - Spalte 2, Zeile 69 * | 2 | |
| A | ELECTRONIC DESIGN, Band 17, Nr. 13, 21. Juni 1969, Seiten 87-88, Rochelle Park, US; G.V. BUTLER: "Build versatile counters with D-type flip-flops" * Figuren 1-3; Seiten 87-88 * | 1,3-5,8 | |
| A | US-A-3 571 573 (OTT) * Figur 1; Spalte 2, Zeilen 1-16 * | 1,4,6,8 | RECHERCHIERTE SACHGEBIETE (Int. Cl.4) H 03 K |

Der vorliegende Recherchenbericht wurde für alle Patentansprüche erstellt

| Recherchenort | Abschlußdatum der Recherche | Prüfer |
|---|---|---|
| DEN HAAG | 02-05-1989 | FEUER F.S. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes Dokument